# EUROPEAN PATENT SPECIFICATION

(11) **EP 2 003 649 B1**
(45) Date of publication and mention of the grant of the patent: **17.08.2011**
(21) Application number: 08157675.3
(22) Date of filing: 05.06.2008
(51) Int. Cl.: G11C 11/00, G11C 16/02, G11C 13/00

(54) **Emulated combination memory device**
Emulierte Kombispeichervorrichtung
Dispositif de mémoire à combinaison d'émulation

(30) Priority: 08.06.2007 US 942894 P; 23.05.2008 US 126738
(43) Date of publication of application: 17.12.2008
(73) Proprietor: Qimonda AG, 81739 München (DE)
(72) Inventor: De Ambroggi, Luca, 81667 München (DE); Dietrich, Stefan, 82299 Tuerkenfeld (DE); Redaelli, Marco, 20048 Carate Brianza, MI (IT); Schroegmeier, Peter, 81547 München (DE)
(74) Representative: Viering, Jentschura & Partner

(56) References cited:
- WO-A-00/58969
- WO-A-98/29816
- US-A1- 2006 023 503
- US-B1- 6 414 873

## Description

### CROSS-REFERENCES TO RELATED APPLICATIONS

This application claims the benefit of U.S. Provisional Patent Application Ser. No. 60/942,894, filed June 8, 2007, and entitled "Emulated Combination Memory Device", the entire contents and disclosure of which are incorporated herein by reference.

### BACKGROUND

Memory devices are used in essentially all computing applications and in many electronic devices. For some applications, non-volatile memory, which retains its stored data even when power is not present, may be used. For example, non-volatile memory is typically used in digital cameras, portable audio players, wireless communication devices, personal digital assistants, and peripheral devices, as well as for storing firmware in computers and other devices. Non-volatile memory is typically relatively slow, and may stop functioning after a limited number of write cycles. For example, it may take approximately 70 to 100 ns for a read access to a typical flash memory device, and longer for writing. A typical flash memory device may withstand approximately 10⁶ writes before it loses its ability to store data.

Volatile memory, which loses its data when power is not present, typically has faster write speeds than non-volatile memory, and may have faster read speeds, depending on the volatile memory technology. For example, static memories typically have access times for reading and writing below 10 ns. Additionally, most volatile memory technologies may withstand several orders of magnitude more write cycles than most non-volatile memory technologies before losing their ability to store data. For example, some dynamic random access memory (DRAM) technologies may withstand 10¹⁵ write cycles. Volatile memory is used in most computing applications, typically as a "working" memory, storing program instructions that are being executed and temporary data.

A wide variety of memory technologies have been developed. Non-volatile memory technologies include flash memory, magnetoresistive random access memory (MRAM), phase change random access memory (PCRAM), and conductive bridging random access memory (CBRAM). Volatile memory technologies include a variety of dynamic random access memory (DRAM) technologies, as well as static random access memory (SRAM) and pseudo-static random access memory (PSRAM) technologies. Due to the great demand for memory devices, researchers are continually improving memory technology, and developing new types of memory.

Many electronic devices, such as cellular telephones and other portable electronic devices typically use both volatile and non-volatile memories. For example, a typical inexpensive cellular telephone may include between 32 and 128 megabits (Mb) of non-volatile memory, such as NOR-type flash memory, and between 16 and 64 Mb of higher speed volatile memory, such as PSRAM. Currently, it is common practice for these two types of memory to be combined using a multi-chip module that includes separate integrated circuit devices for the non-volatile memory and the volatile memory.

US 6 414 873, against which the preamble is based on, discloses a non-volatile static random access memory (nvSRAM) in which there are at least two non-volatile memory cells associated with each volatile SRAM memory cell. The data bits existing in the SRAM cells can be stored in the non-volatile memory cells and then later recalled to the SRAM cells. The data carried in the bit lines BLT and BLC can be transferred to the non-volatile memory cells via the SRAM cells.

### SUMMARY OF THE INVENTION

The invention is disclosed according to the apparatus claim 1 and to the method claim 15.

### BRIEF DESCRIPTION OF THE DRAWINGS

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:

FIG. 1 shows a block diagram of a conventional mobile electronic device and a mobile electronic device using an integrated circuit memory device according to an embodiment of the invention;

FIG. 2 shows a data flow for an example integrated circuit memory device in accordance with an embodiment of the invention;

FIGS. 3A-3D are block diagrams showing an example architecture and buffering operation of an integrated circuit memory device in accordance with an embodiment of the invention;

FIG. 4 is a flowchart of a method of writing to an emulated PSRAM or other emulated memory device having relatively low write latency, in accordance with an embodiment of the invention;

FIG. 5 is a block diagram of a structure of a memory buffer used as a cache in accordance with an embodiment of the invention;

FIGS. 6A-6D are flowcharts of methods for operating a buffer or cache using a buffer configuration register in an emulated memory in accordance with an embodiment of the invention;

FIGS. 7A-D are block diagrams showing another example architecture and buffering operation of an integrated circuit memory device in accordance with an embodiment of the invention;

FIGS. 8A-B are block diagrams showing a further example architecture and buffering operation of an integrated circuit memory device in accordance with an embodiment of the invention;

FIG. 9 is a block diagram showing another example architecture of an integrated circuit memory device in accordance with an embodiment of the invention;

FIG. 10 shows a cross-sectional view of an example PCRAM memory element suitable for use with an integrated circuit memory device in accordance with an embodiment of the invention; and

FIG. 11 is a block diagram of an example PCRAM device suitable for use in an integrated circuit memory device in accordance with an embodiment of the invention.

### DETAILED DESCRIPTION OF ILLUSTRATIVE EMBODIMENTS

In accordance with an embodiment of the invention, the functionality of both a non-volatile memory device and a volatile memory device may be combined in a single integrated circuit, in order to reduce the bill of materials (BOM) and cost of typical electronic devices such as cellular phones, while maintaining or increasing their performance. This may be achieved, for example, using an advanced non-volatile memory technology, such as PCRAM, in an architecture that permits emulation of both a non-volatile memory device, such as a NOR flash memory device, and a volatile memory device, such as a PSRAM device. This approach may provide reduced costs and increased flexibility, since (for example) the portion of the PCRAM that is used to emulate NOR flash, and the portion that is used to emulate PSRAM may be changed according to the application, without requiring changes in the hardware.

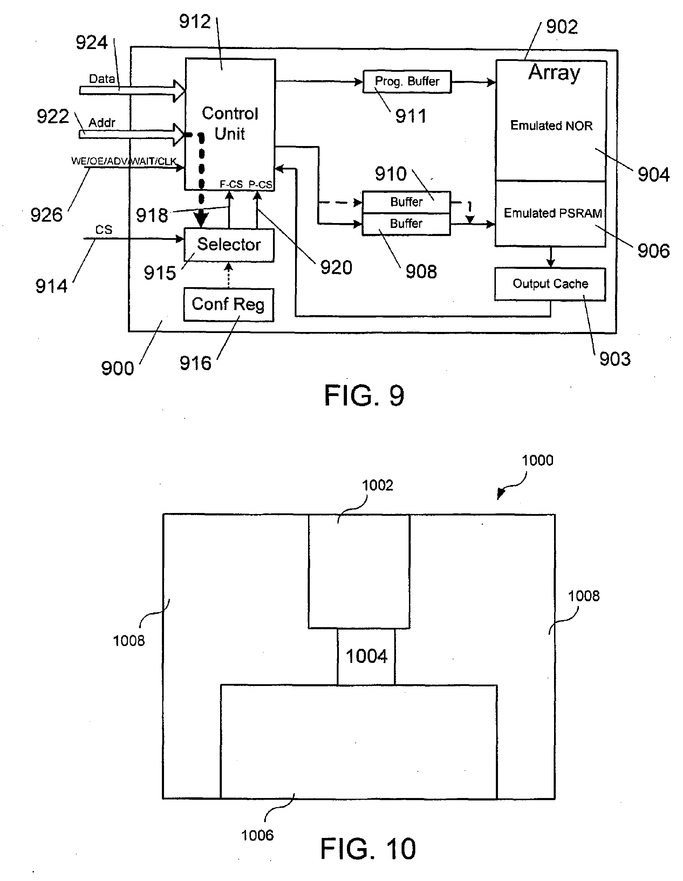

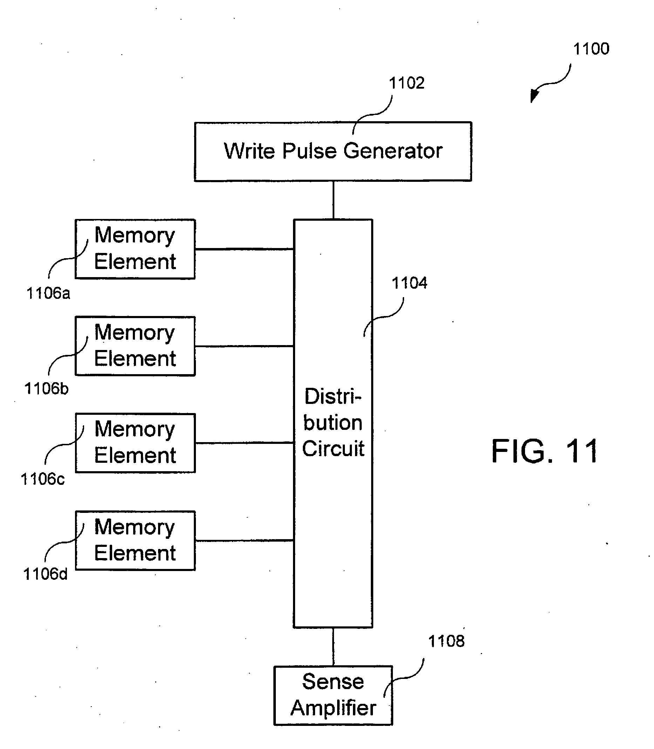

For convenience, in the following discussion, the advanced non-volatile memory technology that is used to emulate other non-volatile and volatile memories will be assumed to be PCRAM, while the non-volatile memory being emulated will be NOR flash memory, and the volatile memory being emulated will be PSRAM. A PCRAM device is described below with reference to FIGS. 10 and 11. NOR flash and PSRAM, such as are emulated by various embodiments of the invention, are commercially available from numerous vendors. For example, PSRAM devices for use in cellular telephones and other portable electronic devices are commercially available from Micron Technology, Inc., of Boise, Idaho, and are described in datasheets (e.g., the datasheet for the Micron MT45W8MW16BGX memory device) available from Micron Technology, Inc. NOR flash memory devices for use in cellular telephones and other portable electronic devices are commercially available, for example, from Intel Corporation, of Santa Clara, California, and are described in datasheets (e.g., the datasheet for the Intel L18 memory device) available from Intel Corporation. It will be understood that other advanced non-volatile memory technologies, such as CBRAM, carbon memories, MRAM, or other non-volatile memory technologies could be used instead of PCRAM, and that other types of volatile and non-volatile memories could be emulated using techniques similar to those described below.

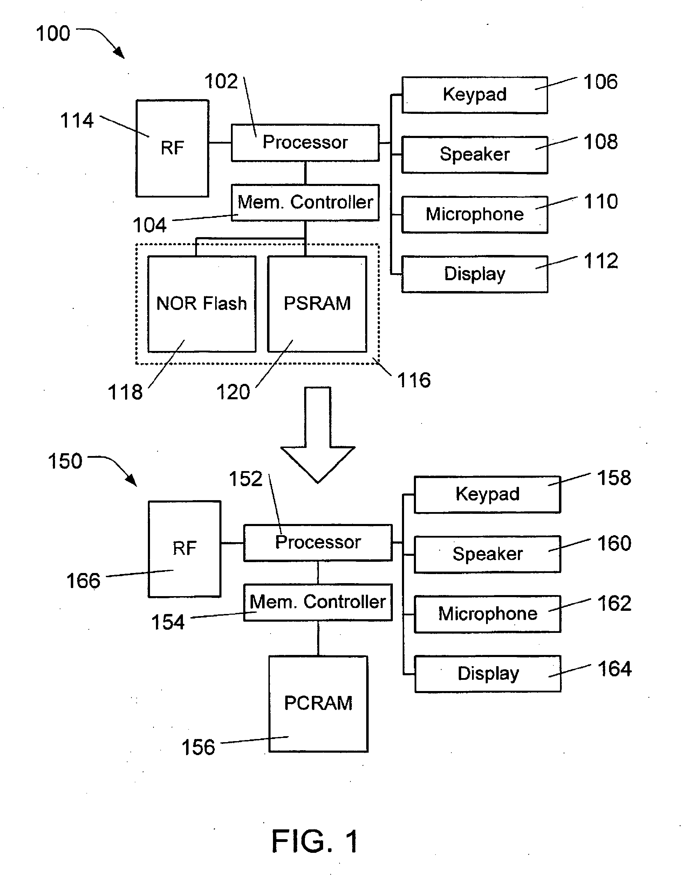

FIG. 1 illustrates some differences between a conventional mobile device 100, and a mobile device 150 using a memory in accordance with an embodiment of the invention. The conventional mobile device 100, which may, for example, be a cellular telephone, includes "standard" components such as a processor 102, memory controller 104, keypad 106, speaker 108, microphone 110, display 112, and RF communication module 114. The conventional mobile device 100 also includes a memory system 116, including a NOR flash memory 118 and a separate PSRAM 120. For example, the NOR flash memory 118 may be used as data and program memory, and may range from 32 to 128 Mb in size. The PSRAM 120 may, for example, be used as working memory, and may range in size from 16 to 64 Mb.

The mobile device 150, shown in the lower portion of FIG. 1, uses a memory system in accordance with an embodiment of the invention. The device includes substantially the same processor 152, memory controller 154, and various I/O devices (e.g., keypad 158, speaker 160, microphone 162, display 164, RF communication module 166), but has only a single integrated circuit memory device - a PCRAM 156. In accordance with an embodiment of the invention, the PCRAM 156 emulates the functionality of the NOR flash memory 118 and a PSRAM 120. As was explained above, other types of nonvolatile memory devices could be used instead of PCRAM 156, in accordance with various embodiments of the invention.

One feature of the mobile device 150, in accordance with an embodiment of the invention, is that it uses fewer components, and may cost less to manufacture when compared with the conventional mobile device 100, while providing substantially the same or improved functionality. Of course, there are some issues that should be addressed to provide a memory such as is used in the mobile device 150. First, there is an issue with the endurance and reliability of a non-volatile memories, such as PCRAM 156. Volatile memories, such as PSRAM 120 have effectively infinite read and write cycles, whereas most non-volatile technologies, such as PCRAM 156, may be rewritten only a limited number of times.

An additional issue for emulating a PSRAM using PCRAM 156 relates to performance. While PCRAM 156 will have no problem matching (or beating) the performance of NOR flash memory 118, the write speed of PSRAM 120 is considerably faster than the write speed of PCRAM 156. Similarly, the write latency for PCRAM 156 is much longer than the write latency for PSRAM 120. For example, for PSRAM 120, the write latency would typically be approximately 10 ns, while the write latency for PCRAM 156 would typically be on the order of 70 to 100 ns. As a result of its slow write speeds, PCRAM 156 and other non-volatile memory devices typically use a signal to indicate that they are busy following a write command, while PSRAM 120 may not need such a signal.

Another issue for such emulation is that the interfaces and commands of NOR flash 118 and PSRAM 120 are different, and both may be different from the interfaces and commands used by PCRAM 156. The timing of commands may be different, as well as the nature and sequence of the commands that are used for reading and writing. For example, reading and writing to a PSRAM device, such as PSRAM 120, would typically be simple, and might involve placing appropriate values on the address lines and (for writing) the data lines, and using one or more control lines to indicate that a read or write operation should be performed. Reading and writing to a flash memory device, such as NOR flash memory 118, is typically more complex, and may involve the use of command codes that are placed into a program buffer in the memory device. To emulate both of these types of devices using PCRAM 156, while keeping the emulation reasonably transparent, both interfaces, including commands and (in some embodiments) timing may be emulated.

A further issue involves mapping of memory address space. Where a portion of PCRAM 156 is used to emulate NOR flash, and a portion is used to emulate PSRAM, there may be issues related to selecting and mapping the addresses for each of these emulated types of memory.

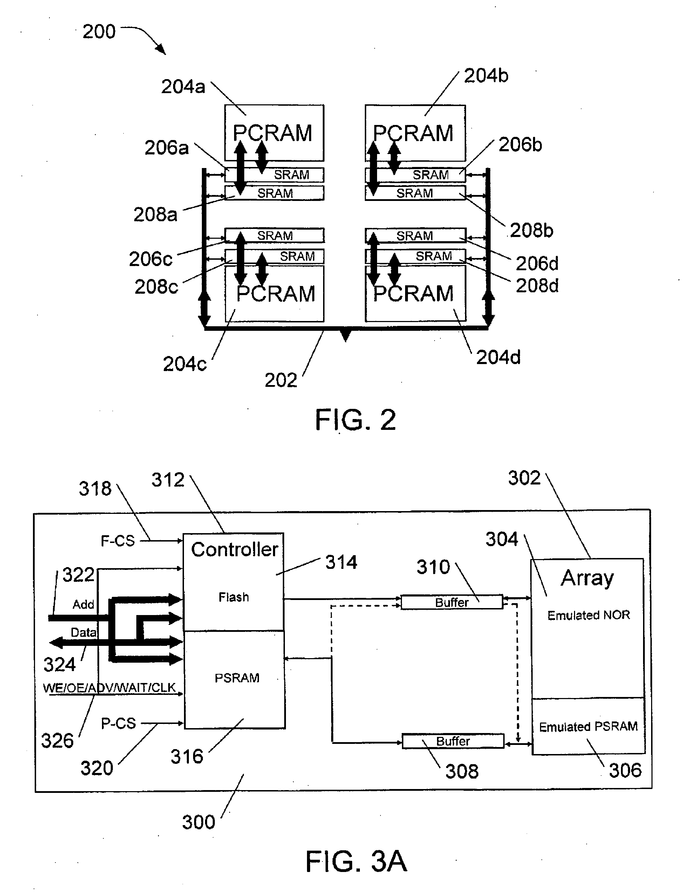

FIG. 2 shows a general data flow for an example 512 Mb integrated circuit memory device 200 in accordance with an embodiment of the invention. Data are transferred over a bus 202 into or out of four 128 Mb PCRAM arrays, 204a, 204b, 204c, and 204d via either an emulated PSRAM device or an emulated NOR flash device. Two 1 Kb SRAM buffers 206a - 206d and 208a - 208d may be associated with each of the four PCRAM arrays 204a - 204d for use in emulating PSRAM and for use as a program buffer for emulated NOR flash, as described below.

An example architecture for an integrated circuit memory device 300 in accordance with an embodiment of the present invention is shown in FIG. 3A. The memory device 300 includes a PCRAM array 302 that is divided into an emulated NOR flash region 304 and an emulated PSRAM region 306. A first SRAM buffer 308 and a second SRAM buffer 310 may be used to read and write data in order to permit emulation of the relatively high speed operation of PSRAM by PCRAM, which may be slower than PSRAM, as will be explained in detail below. Due to the relatively high cost of SRAM, the first SRAM buffer 308 and second SRAM buffer 310 may be relatively small in capacity, compared to the PCRAM array 302. For example, the PCRAM array 302 may be 512 megabits (Mb) in size, while the first SRAM buffer 308 and second SRAM buffer 310 may each be 4 kilobits (Kb) in size. It will be understood that the PCRAM array 302 may be made up of numerous smaller arrays, and the first SRAM buffer 308 and second SRAM buffer 310 may be made up of numerous smaller SRAM buffers, for example as described above with reference to FIG. 2.

The memory device 300 may further include a controller 312 that includes a flash control portion 314 and a PSRAM control portion 316. A flash "chip select" line, F-CS 318 is directed to, and enables the flash control portion 314, while a PSRAM "chip select" line, P-CS 320 is directed to, and enables the PSRAM control portion 316. Address lines 322, data lines 324, and a control lines 326, which may include a write enable (WE) line (not shown), an output enable (OE) line (not shown), an address valid (ADV) line (not shown), a WAIT line (not shown), and a clock (CLK) line (not shown), are shared by both the flash control portion 314 and the PSRAM control portion 316.

In accordance with an embodiment of the invention, the separate flash and PSRAM select lines, F-CS 318 and P-CS 320, respectively determine the type of memory being emulated. For example, NOR flash functionality may be activated by the flash "chip select" line F-CS 318, while PSRAM functionality may be activated by the PSRAM "chip select" line P-CS 320. Since the NOR flash and PSRAM are being emulated on a single integrated circuit, these lines (individually) do not actually enable or disable the integrated circuit, but are instead used to indicate which interface and commands should be emulated and/or enabled. When the F-CS line 318 is enabled, then the device will provide the functionality and interface of a NOR flash device, as specified, for example, in the datasheet of a typical commercially available NOR flash memory device. When the P-CS line 320 is enabled, then the device will provide the functionality and interface of a PSRAM device, as found, for example, in the data sheet of a standard, commercially available PSRAM device.

In some embodiments, some of the control lines, such as the F-CS 318 and P-CS 320 chip enable lines, may be separate for each of the emulated memory devices, while other lines, such as the address lines 322 and data lines 324, as well as some the control lines 326 such as write enable (WE) and/or output enable (OE) lines, may be shared. In some embodiments, the control functions for each of the emulated memory devices not only emulate the functionality of volatile and non-volatile memory devices, such as PSRAM and NOR flash, but also emulate the timing, such as bus turn-around timing, of such devices. In some embodiments, the functionality, timing, and positions of the lines are matched as closely as possible, to minimize the amount of redesign that is needed to switch from a multi-chip module to a single integrated circuit that emulates the functionality of the separate memory chips on such a multi-chip module.

In the physical packaging (not shown) for a memory device in accordance with an embodiment of the invention, such as the memory device 300, pins (not shown) for these shared lines may be shared pins, while signals specific to flash memory may be on pins (not shown) that are connected to the flash control portion 314, and signals specific to PSRAM may be on pins (not shown) that are connected to the PSRAM control portion 316. In this way, the interface and protocol may be kept separate between the PSRAM and NOR flash emulation in some embodiments.

The division of the PCRAM array 302 into the NOR flash region 304 and the emulated PSRAM region 306 may vary. For example, in some embodiments, a static mapping can be used, in which a fixed portion of the address space of the PCRAM array 302 is mapped for use as the emulated PSRAM region 306, and a fixed portion is mapped for use as the emulated NOR flash region 304. In some embodiments, the memory device 300 may emulate separate address spaces for the emulated PSRAM region 306 and emulated NOR flash region 304, and map the two address spaces onto a single address space in the PCRAM array 302. In some embodiments, the boundary between the portion of the PCRAM array 302 that is used for the emulated PSRAM region 306 and the portion that that is used for the emulated NOR flash region 304 may be flexible, permitting the amount of each type of memory that is provided by the emulation to be changed.

In some embodiments the emulated PSRAM region 306 and emulated NOR flash region 304 within the PCRAM array 302 may be dynamically mapped. For example, the controller 312 may add a dynamic offset to the external address to determine the address in the PCRAM array 302 where the data will be stored. Such dynamic address mapping may also be used to address issues related to the endurance and reliability of PCRAM. Dynamic mapping may be used to map out portions of the PCRAM array 302 that are unusable, and may also be used for wear leveling, to map the emulated PSRAM region 306 to varying areas of the PCRAM array 302, so that no one area of the PCRAM array 302 is subject to substantially more write cycles than other portions. Using such wear leveling techniques, a PCRAM device should be able to handle the normal write load of a typical PSRAM device without failure due to a limited number of write cycles for a long period of time - typically longer (perhaps decades longer) than the useful lifespan of a typical portable electronic device.

When the memory device 300 is emulating a NOR flash device, the second SRAM buffer 310 may be used as the program buffer for the emulated NOR flash device. When the memory device 300 is emulating a PSRAM device, then the first SRAM buffer 308 and the second SRAM buffer 310 may be used to provide a double-buffering, to handle the difference in performance between PSRAM and PCRAM. Data that is to be written to the emulated PSRAM region 306 of the PCRAM array 302 is written to one of the buffers, for example the first SRAM buffer 308, which has a write speed and latency that is at least as fast as a typical PSRAM device. When the first SRAM buffer 308 is full, the contents of the first SRAM buffer 308 may be internally transferred to appropriate locations in the PCRAM array 302, while new data that is to be written to the emulated PSRAM region 306 is written to the second SRAM buffer 310. Hopefully, by the time the second SRAM buffer 310 is full, the contents of the first SRAM buffer 308 will have been transferred to the PCRAM array 302, so that the buffers can again be swapped, and writing to the emulated PSRAM can continue in one of the buffers, while the contents of the other buffer are being transferred to PCRAM.

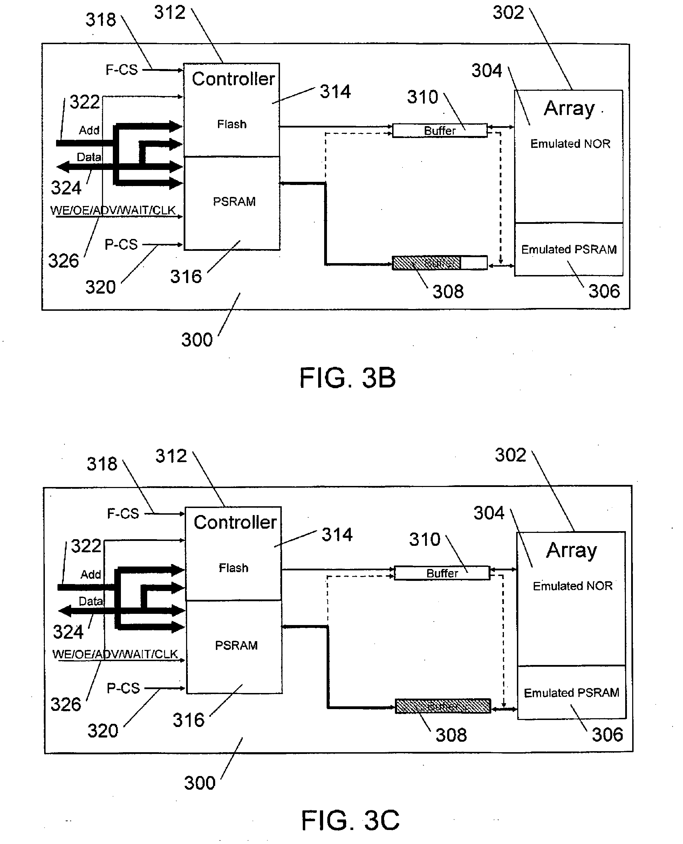

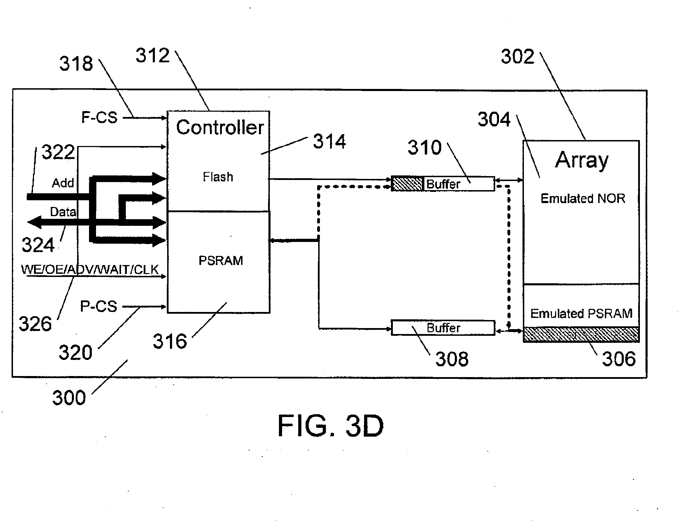

This process is illustrated in FIGS. 3B - 3D. In FIG. 3B, the memory device 300 is emulating a PSRAM device, and data that are to be written to the emulated PSRAM device are written to the first SRAM buffer 308, which is not yet full. In FIG. 3C, the first SRAM buffer 308 has been filled, so transfer of data from the first SRAM buffer 308 to the emulated PSRAM region 306 may begin, while new incoming data for the emulated PSRAM device may be stored in the second SRAM buffer 310. In FIG. 3D, the data from the first SRAM buffer 308 has been transferred to the emulated PSRAM region 306 of the PCRAM array in the background, while incoming data are stored in the second SRAM buffer 310.

It should be noted that although the embodiment shown in FIGs. 3A - 3D has two SRAM buffers, some embodiments may have more than two such buffers. Additionally, the sizes of such buffers may vary.

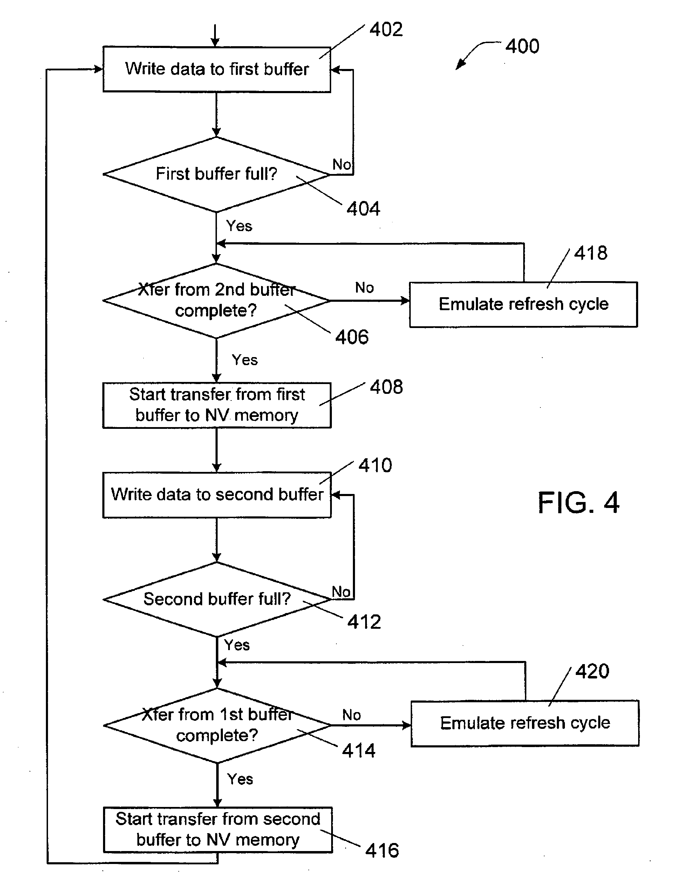

While use of two (or more) buffers, as illustrated above, may address many of the write latency issues associated with emulating PSRAM or other low-latency memories using PCRAM or other advanced memories having a higher write latency than PSRAM, there may be some cases where the buffers will not be sufficient. For example, if the transfer of data in the first buffer to PCRAM is still being handled when the second buffer fills, it may be necessary to delay further writing until the transfer to PCRAM is complete. In these instances, it may be useful to delay writing to the emulated PSRAM while data are transferred from a buffer to the PCRAM. FIG. 4 shows a method 400 of emulating writing to a PSRAM device and causing such a delay.

In 402, data are written to a first low write latency buffer, such as an SRAM buffer. In 404, if the first buffer is not yet full, then writing can continue (e.g., in 402). In 406, when the first buffer is full, then (as discussed below) a check is made to see if any transfer of data from the second buffer to the non-volatile memory has finished. If so, then in 408 the memory system starts to transfer the data in the first buffer to the non-volatile memory (which may, e.g., be PCRAM or another type of non-volatile memory). While this transfer is occurring, in 410, data are written to a second low write latency buffer, such as a second SRAM buffer. In 412, if the second buffer is not yet full, then writing may continue in the second buffer (e.g., in 410). If the second buffer is full, then in 414, a check is made to see whether the transfer from the first buffer is complete. If so, then in 416, a transfer of data from the second buffer to the non-volatile memory starts, and the process returns to 402, in which data are written to the first buffer. In 406, if a transfer of data from the second buffer to the non-volatile memory is not finished (assuming that any such transfer is taking place), then at 418 the system delays further writes to the memory by emulating a refresh cycle. Once the transfer from the second buffer is complete, then the emulated refresh cycle will end, and writing to the memory may continue. Similarly, at 414, if the second buffer is full, but a transfer from the first buffer is not complete, then at 420, the system delays further writes to the memory by emulating a refresh cycle, until the transfer from the first buffer completes.

Emulating a refresh cycle in 418 and 420 can be used to delay further writing because a conventional (i.e., non-emulated) PSRAM device occasionally delays write (and read) operations while it performs an internal refresh operation. In accordance with an embodiment of the invention, delays due to transfer of data from a buffer to PCRAM, or other delays related to the write latency of PCRAM or other non-volatile memories may be disguised as normal PSRAM refresh delays. Since PCRAM and other non-volatile memories do not require refresh, such memories would normally not require any refresh delays. However, in accordance with an embodiment of the invention, the refresh delays occurring in a typical PSRAM device may be used in an emulated PSRAM device to hide the difference in write latency. For the emulation to maintain a high degree of transparency, the length of the delays due to write latency differences may be similar to the length of the refresh delays in a conventional PSRAM device. Depending on the application in which the memory is being used, the size and number of the buffers can be selected to achieve such similar delay lengths.

In some embodiments of the invention, the SRAM buffer (or buffers), or a portion of the buffer may be used as a more general cache for PSRAM emulation, rather than just for writing to the PCRAM. The buffer may be used to permit fast read and write access to data until the buffer is full, at which time the buffer may be written to PCRAM. In some embodiments, a buffer "flush" command may also be issued to cause the contents of the buffer (or a portion of a buffer) to be written to PCRAM.

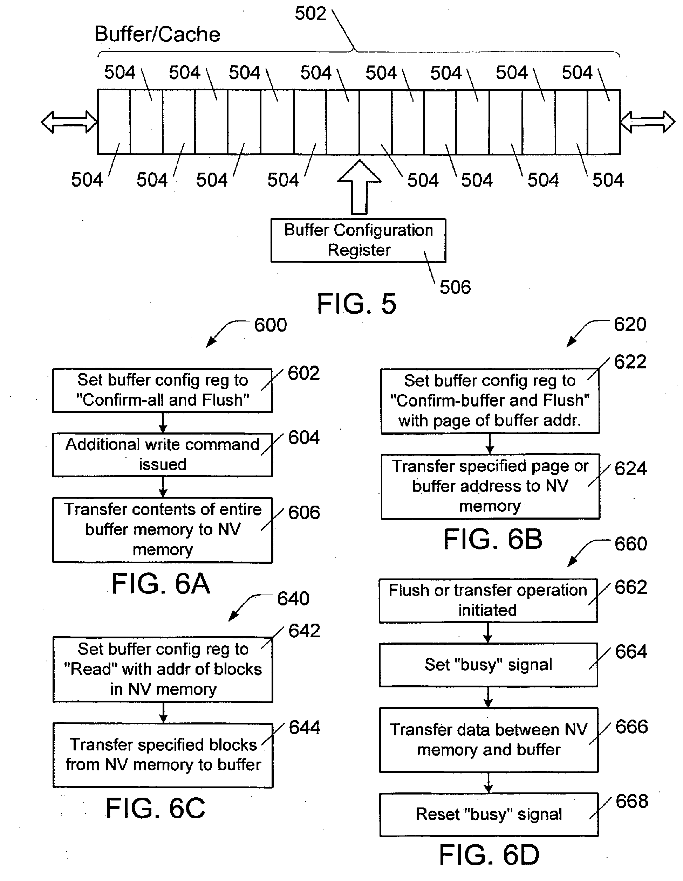

FIG. 5 shows the structure of a sample buffer used as a cache. The buffer memory 502, which may be a relatively fast memory, such as SRAM, is divided into numerous page buffers 504. In the embodiment shown in FIG. 5, there are 16 page buffers 504 in the buffer memory 502. When PSRAM is being emulated, each write command stores a page address and a block of words in one of the page buffers 504. The block of words may, for example, be equal to the number of words that may be read or written in a single burst-mode read or write command to the PSRAM device that is being emulated. If a read command is issued with an address corresponding to any of the pages that are stored in the page buffers 504, the data may be directly read out of the buffer.

In some embodiments, the buffer memory 502 may also be associated with a buffer configuration register 506. The buffer configuration register 506 may be part of the buffer memory 502, or part of a memory controller (not shown) that controls PSRAM emulation. Access to the buffer configuration register 506 may be memory-mapped, or may occur through other access means, such as through a special buffer configuration command sent to the memory controller. As will be discussed below, by writing to the buffer configuration register 506, the buffer memory 502 may be configured and/or controlled, for example to affect the transfer of data into and out of the buffer. In some embodiments, a single buffer configuration register 506 may be used to configure and control numerous buffer memories in a memory device. In other embodiments, each buffer memory may be associated with its own buffer configuration register, such as the buffer configuration register 506.

Using a buffer memory configured as a cache, such as the buffer memory 502, individual pages can be moved to non-volatile memory, such as PCRAM when the buffer is full. For example, this may be done in a LIFO (last-in first-out) manner, so that the newest pages written are moved to PCRAM, while the old data is kept in the buffer. Other orders for transferring data may also be used.

In some embodiments, the buffer configuration register 506 can be used to determine when the contents of the buffer memory 502 are flushed to PCRAM. As shown in FIGS. 6A - 6D there are various methods for controlling the contents of the buffer memory 502 in association with the buffer configuration register 506. Depending on the contents of the buffer configuration register, and the way in which the buffer(s) are used, the memory device may be configured for various types of performance. For example, the memory device could be configured for speed (e.g., as for DRAM), middle endurance for data storage (e.g., as for NAND flash), high retention (e.g., for code storage), etc.

FIG. 6A shows a first such method 600. In 602, the buffer configuration register 506 is set to a "Confirm-all and Flush" state. In 604, an additional write command is issued. In 606, this additional write command, in combination with the state of the buffer configuration register 506 causes the transfer of all of the contents of the buffer memory to the non-volatile memory, such as a PCRAM array. This transfer may occur, for example, in a sequential order. In some embodiments, simply setting the buffer register to a "Confirm-all and Flush" state will cause the transfer of data, without the additional write command of 604.

FIG. 6B shows another such method 620. In 622, the buffer configuration register 506 is set to a "Confirm-buffer and Flush" state. A page or buffer address to be flushed to the non-volatile memory array is also supplied. In 624, this causes the specified page in the buffer to be transferred to the non-volatile memory array.

As shown in FIG. 6C, a similar method 640 may be used to transfer data from the non-volatile memory array to a buffer, to facilitate more rapid reading of data in an emulated PSRAM device (though it should be noted that for some types of non-volatile memory, such as PCRAM and other advanced non-volatile memories, there may be little or no difference in read speed between the non-volatile memory and the PSRAM that is being emulated). In 642, the buffer configuration register 506 is set to a "Read" state, and the address of one or more blocks in the non-volatile memory array are specified. Optionally, the page buffers into which the data are to be transferred may also be specified. In 644, Data are transferred from the specified address range in the PCRAM into the buffer, where they will be available for rapid reading.

In some embodiments, when transfers are occurring between the non-volatile memory array and the buffer, it may be necessary to block the execution of other commands.
FIG. 6D shows a method 660 for handling this. In 662 a flush or transfer operation between the buffer and the PCRAM is initiated (and, in some embodiments, no other buffer is available to permit commands to continue being issued). Such flush or transfer operations may be initiated, for example, as shown in the methods 600, 620, and 640 of FIGS. 6A-6C. In 664, a busy signal, or other signal indicating that the device is unable to accept commands is set to an "on" state. This busy signal may be available as output from the memory device, for example, on a busy pin, and/or (as discussed above) could be "disguised" as a refresh cycle that is typically needed on a PSRAM device or DRAM. In 666, the transfer between the buffer and the non-volatile memory takes place. Once the transfer is done, then in 668, the busy signal is reset to an "off" state, and commands may continue being processed.

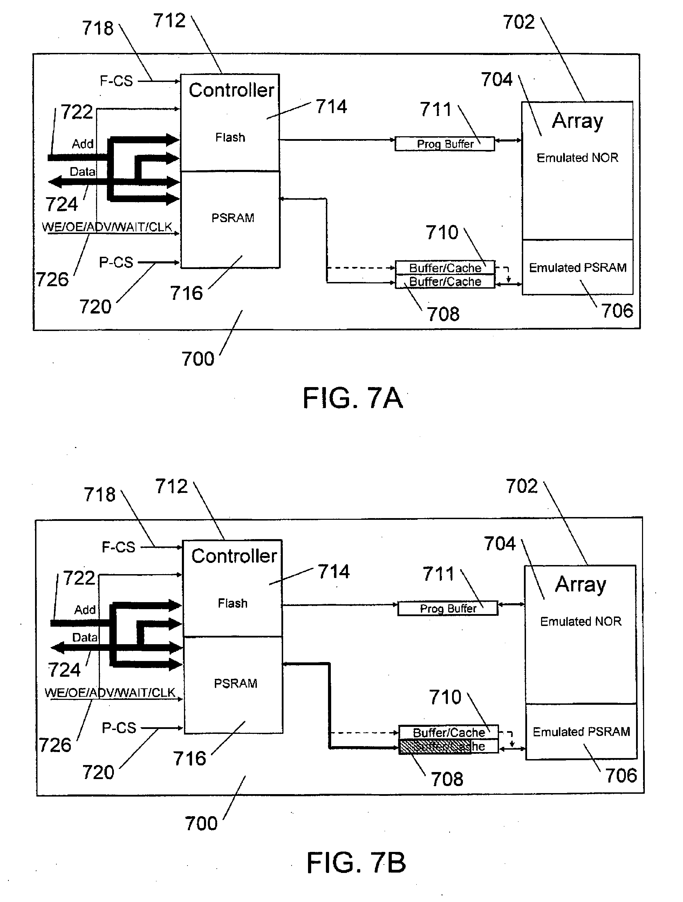

Referring now to FIG. 7A, a second architecture for an integrated circuit memory device in accordance with an embodiment of the invention is described. The memory device 700 includes a PCRAM array 702 that is divided into an emulated NOR flash region 704 and an emulated PSRAM region 706. A first SRAM buffer 708 and a second SRAM buffer 710 may be used to read and write data during PSRAM emulation. The memory device 700 further includes a separate program buffer 711, which is used to store commands and/or data for use when the device is emulating a NOR flash memory, or other non-volatile memory. Generally, the size of the program buffer 711 will be determined by the length (i.e., the number of bits) that are needed to issue commands, and provide addresses and data to the emulated NOR flash memory. For example, a 0.5 Kb program buffer may be sufficient for many applications. As before, it will be understood that in some embodiments the PCRAM array 702 may be made up of numerous smaller arrays. Additionally, in some embodiments, the first SRAM buffer 708, second SRAM buffer 710, and/or the program buffer 711 may be made up of numerous smaller buffers, for example as described above with reference to FIG. 2.

The memory device 700 may further include a controller 712 that includes a flash control portion 714 and a PSRAM control portion 716. In various embodiments, the controller 712 may be a state machine, a microcontroller, a processor, spare logic that runs an algorithm as described below, or other types of electronic control circuitry. In some embodiments, the controller 712 may be integrated into the memory device 700, while in other embodiments, it may be external.

A flash "chip select" line, F-CS 718 is directed to, and enables the flash control portion 714, while a PSRAM "chip select" line, P-CS 720 is directed to, and enables the PSRAM control portion 716. Address lines 722, data lines 724, and a control lines 726, which may include a write enable (WE) line (not shown), an output enable (OE) line (not shown), an address valid (ADV) line (not shown), a WAIT line (not shown), and a clock (CLK) line (not shown), are shared by both the flash control portion 314 and the PSRAM control portion 716.

In this embodiment, when the memory device 700 is emulating flash memory, such as NOR flash memory, the program buffer 711 receives data to be stored in the emulated flash memory. Similarly, when the memory device 700 is emulating PSRAM, the first SRAM buffer 708 and second SRAM buffer 710 provide a double buffer approach to handling differences in the write latency between PSRAM and advanced non-volatile memories, such as PCRAM, as described above. Additionally, depending on the bus architecture, in some embodiments, the buffers 708, 710, and 711 may be used to permit reading from one type of emulated memory while writing to another. For example, once data for writing to emulated NOR have been placed in the program buffer 711, the data can be written to the emulated NOR memory while data are read from emulated PSRAM into the SRAM buffers 708 and/or 710.

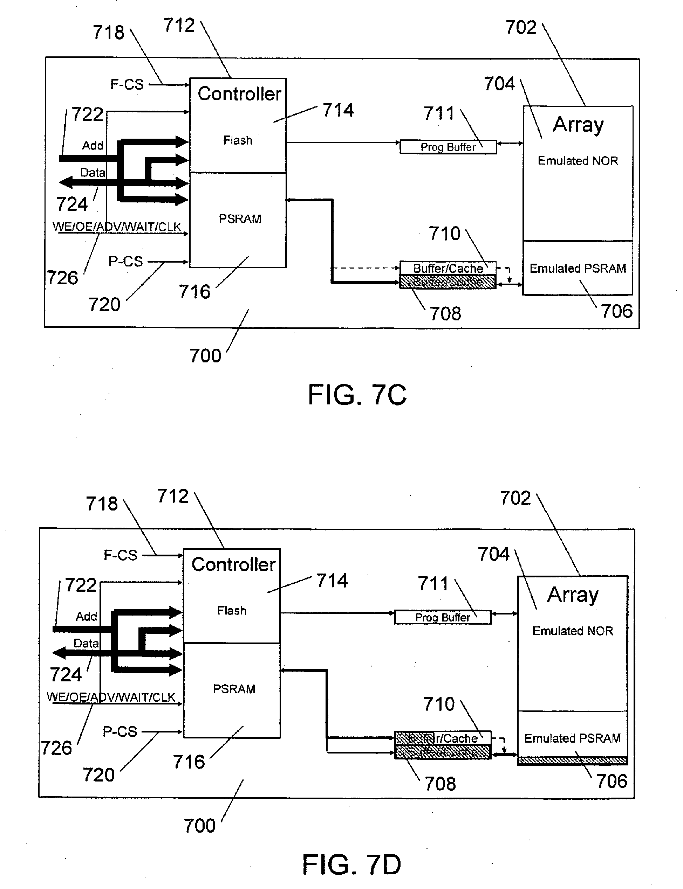

Operation of a double buffer approach to handling differences in the write latency between PSRAM and advanced non-volatile memories, such as PCRAM, is shown in FIGS. 7B-7D. In FIG. 7B, the memory device 700 is emulating a PSRAM device, and data that are to be written to the emulated PSRAM device are written to the first SRAM buffer 708, which is not yet full. In FIG. 7C, the first SRAM buffer 708 has filled, so transfer of data from the first SRAM buffer 708 to the emulated PSRAM region 706 may begin, while new incoming data for the emulated PSRAM device may be stored in the second SRAM buffer 710. In FIG. 7D, the data from the first SRAM buffer 708 has been transferred to the emulated PSRAM region 706 of the PCRAM array in the background, while incoming data are stored in the second SRAM buffer 710.

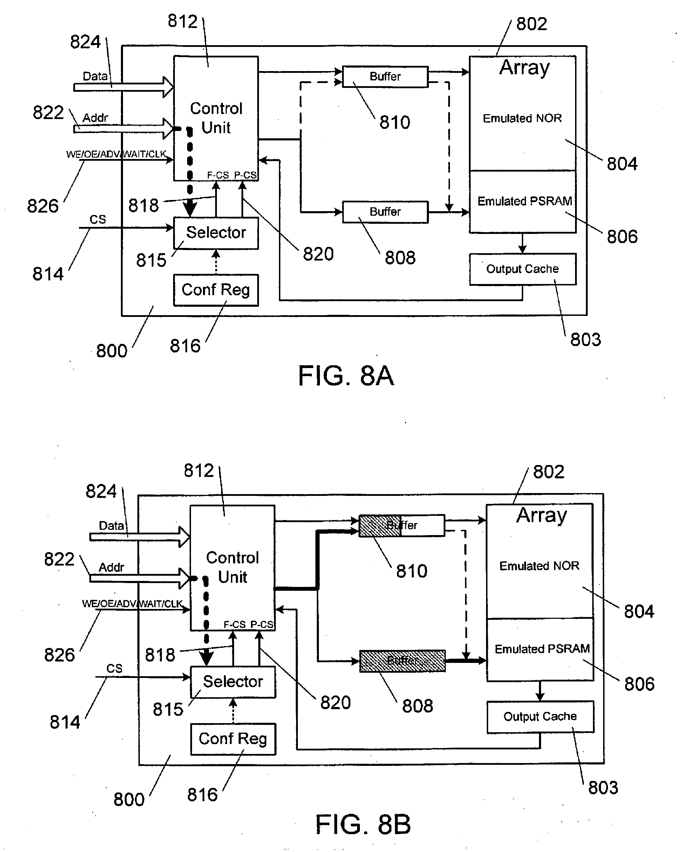

FIG. 8A shows another example architecture for an integrated circuit memory device 800 in accordance with an embodiment of the invention. The memory device 800 shown in FIG. 8 emulates both a high-speed memory such as PSRAM, and a lower speed non-volatile memory, such as NOR flash memory, but provides only a single, unified interface, which does not necessarily maintain compatibility with a PSRAM or a NOR flash interface. For example, the interface to the memory device 800 may be PSRAM-like with some extended commands for use with NOR flash emulation.

The memory device 800 includes a PCRAM array 802 that is divided into an emulated NOR flash region 804 and an emulated PSRAM region 806. A first SRAM buffer 808 and a second SRAM buffer 810 may be used to read and write data during PSRAM emulation. During NOR flash emulation, the second SRAM buffer 810 may be used as a program buffer, to store NOR flash commands and/or data. Data read from the PCRAM array 802 may be stored in an output cache 803, which may be, for example, a set associative cache. The output cache may be any relatively high speed memory, such as SRAM. It will be understood that such an output cache may be added to other embodiments described herein. Also, as before, in some embodiments the PCRAM array 802 may be made up of numerous smaller arrays. Additionally, in some embodiments, the first SRAM buffer 808, second SRAM buffer 810, and/or output cache 803 may be made up of numerous smaller buffers, for example as described above with reference to FIG. 2. Additionally, as with all embodiments described herein, in some embodiments, the array 802 may use non-volatile memory tapes other than PCRAM, and the memory device 802 may emulate memory types other than PSRAM and NOR flash.

The memory device 800 may further include a controller 812. In the embodiment shown in FIG. 8A, the controller 812 is a common control unit, that receives commands for both PSRAM emulation and NOR flash emulation. As above, in various embodiments, the controller 812 may be a state machine, a microcontroller, a processor, spare logic that runs an algorithm as described below, or other types of electronic control circuitry. In some embodiments, the controller 812 may be integrated into the memory device 800, while in other embodiments, it may be external.

The memory device 800 includes only a single chip select (CS) line 814, which is used for both PSRAM and flash emulation. Internally, a flash "chip select" line (F-CS) 818 and a PSRAM "chip select" line (P-CS) 820 may be used to indicate to the controller 812 which type of memory is to be emulated, but such lines are not a part of the external interface to the memory device 800.

The type of emulation that is to be used in memory device 800 at any given time may be determined according to the address that is being accessed, the contents of a configuration register 816, and/or the status of the CS line 814. For example, if the CS line 814 is asserted and the address is one that is associated with the emulated PSRAM, then the device can internally select PSRAM emulation, and assert the P-CS line 820. Similarly, if the CS line 814 is asserted and the address is associated with the emulated flash memory, then the device can internally select NOR flash emulation, and assert the F-CS line 818. This address memory mapping information may be kept, for example, in the configuration register 816, which may be used in some embodiments to dynamically determine which blocks of addresses are used to emulate flash memory, and which are used to emulate PSRAM. Also, as will be described below, in some embodiments, the configuration register 816 may be used to send NOR flash commands to the memory device 800. In some embodiments, if the CS line 814 is asserted, and the configuration register 816 is configured to issue a NOR flash command, then the memory device 800 will emulate a NOR flash memory, and the internal F-CS line 818 will be asserted. In some embodiments, the determination of whether to emulate NOR flash or PSRAM is made in a selector 815 within the memory device 800.

The memory device 800 also includes address lines 822, data lines 824, and control lines 826, which may include a write enable (WE) line (not shown), an output enable (OE) line (not shown), an address valid (ADV) line (not shown), a WAIT line (not shown), and a clock (CLK) line (not shown). These lines may be used for both flash emulation and PSRAM emulation. In the memory device 800, independent of the incoming address, the NOR and PSRAM emulation may have the same command interface for basic commands, such as Read, Write, Burst Read, Burst Write, Read/Set Registers, Standby, and/or Deep Power Down. Certain NOR-specific features and commands, such as Suspend/Resume, Protection, Lock, CFI Read, Device ID, Read Status, and other NOR-specific commands may be handled using a configuration register, such as the configuration register 816.

Similar to the embodiment described with reference to FIGS. 3A-3D, the memory device 800 may use a double buffering approach during PSRAM emulation to handle write latency differences between the PSRAM that is being emulated and the PCRAM array 802. As seen in FIG. 8B, when the first SRAM buffer 808 is full, data may be transferred from the first SRAM buffer 808 to the PCRAM array 802, while incoming data is kept in the second SRAM buffer 810. In some embodiments, during a synchronous read operation, multiple words may be sensed and transferred into the first SRAM buffer 808, the second SRAM buffer 810, and/or the output cache 803. In some embodiments, during a synchronous write operation, the first SRAM buffer 808 may be used to buffer pages during a write to the PCRAM array 802, while the second SRAM buffer 810 is used to keep volatile data for fast access both reading and writing.
It will be understood that when used in this manner, the buffers may be reversed, so the first SRAM buffer 808 is used to keep volatile data for fast access, while the second SRAM buffer 810 buffers pages during a write to the PCRAM array 802. In some embodiments, both the first SRAM buffer 808 and the second SRAM buffer 810 may support cache operation to reduce busy time overhead during write access to the PCRAM array 802.

FIG. 9 shows a similar embodiment, in which the integrated circuit memory device 900 includes a separate program buffer 911. The memory device 900 includes a PCRAM array 902 that is divided into an emulated NOR flash region 904 and an emulated PSRAM region 906. A first SRAM buffer 908 and a second SRAM buffer 910 may be used to read and write data during PSRAM emulation. The memory device 900 further includes a separate program buffer 911, which is used to store commands and/or data for use when the device is emulating a NOR flash memory, or other non-volatile memory. It will be understood that in some embodiments the PCRAM array 902 may be made up of numerous smaller arrays. Additionally, in some embodiments, the first SRAM buffer 908, second SRAM buffer 910, and/or the program buffer 911 may be made up of numerous smaller buffers, for example as described above with reference to FIG. 2.

The memory device 900 may further include a controller 912 that receives commands for both PSRAM emulation and NOR flash emulation. The memory device 900 includes only a single chip select (CS) line 914, which is used for both PSRAM and flash emulation. Internally, a flash "chip select" line (F-CS) 918 and a PSRAM "chip select" line (P-CS) 920 may be used to indicate to the controller 912 which type of memory is to be emulated, but such lines are not a part of the external interface to the memory device 900. As described above with reference to FIG. 8, the type of emulation that is to be used in the memory device 900 at any given time may be determined according to the address that is being accessed, the contents of a configuration register 916, and/or the status of the CS line 914. The determination of whether to emulate NOR flash or PSRAM may be made in a selector 915 within the memory device 900.

The memory device 900 also includes address lines 922, data lines 924, and control lines 926, which may include a write enable (WE) line (not shown), an output enable (OE) line (not shown), an address valid (ADV) line (not shown), a WAIT line (not shown), a clock (CLK) line (not shown), and/or other control lines may be used for both flash emulation and PSRAM emulation. In the memory device 900, the NOR and PSRAM emulation may have the same command interface for certain basic commands, such as Read, Write, Burst Read, Burst Write, Read/Set Registers, Standby, and/or Deep Power Down. Certain NOR-specific features and commands, such as Suspend/Resume, Protection, Lock, CFI Read, Device ID, Read Status, and other NOR-specific commands may be handled using a configuration register, such as the configuration register 916.

When the memory device 900 is emulating flash memory, such as NOR flash memory, the program buffer 911 receives data to be stored in the emulated flash memory. Similarly, when the memory device 900 is emulating PSRAM, the first SRAM buffer 908 and second SRAM buffer 910 provide a double buffer approach to handling differences in the write latency between PSRAM and advanced non-volatile memories, such as PCRAM, as described above. Alternatively, the first SRAM buffer 908 and second SRAM buffer 910 may be used for caching data, as discussed above. In some embodiments the first SRAM buffer 908 and second SRAM buffer 910 may be used as cache memory when the memory device 900 is emulating flash memory, and/or the program buffer 911 may be used as a cache when the memory device 900 is emulating PSRAM. Additionally, as discussed above, depending on the bus architecture, in some embodiments, the buffers 908, 910, and 911 may be used to permit reading from one type of emulated memory while writing to another.

FIGS. 10 and 11 illustrate a PCRAM memory element and the structure of a PCRAM device, respectively. Such PCRAM elements and devices may be used as an "advanced" non-volatile memory, in accordance with various embodiments of the invention. Generally, the memory elements used in PCRAM are phase changing memory elements that include a phase changing material. The phase changing material can be switched between at least two different crystallization states (i.e. the phase changing material may adopt at least two different degrees of crystallization), wherein each crystallization state may be used to represent a memory state. When the number of possible crystallization states is two, the crystallization state having a high degree of crystallization is also referred to as "crystalline state", whereas the crystallization state having a low degree of crystallization is also referred to as "amorphous state". Different crystallization states can be distinguished from each other by their differing electrical properties, and in particular by their different resistances. For example, a crystallization state having a high degree of crystallization (ordered atomic structure) generally has a lower resistance than a crystallization state having a low degree of crystallization (disordered atomic structure). For sake of simplicity, it will be assumed in the following that the phase changing material can adopt two crystallization states (an "amorphous state" and a "crystalline state"), however it will be understood that additional intermediate states also may be used.

Phase changing memory elements may change from the amorphous state to the crystalline state (and vice versa) due to temperature changes of the phase changing material. These temperature changes may be caused using different approaches. For example, a current may be driven through the phase changing material (or a voltage may be applied across the phase changing material). Alternatively, a current or a voltage may be fed to a resistive heater which is disposed adjacent to the phase changing material. To determine the memory state of a resistivity changing memory element, a sensing current may routed through the phase changing material (or a sensing voltage may be applied across the phase changing material), thereby sensing the resistivity of the resistivity changing memory element, which represents the memory state of the memory element.

FIG. 10 illustrates a cross-sectional view of an example phase changing memory element 1000 (active-in-via type). The phase changing memory element 1000 includes a first electrode 1002, a phase changing material 1004, a second electrode 1006, and an insulating material 1008. The phase changing material 1004 is laterally enclosed by the insulating material 1008. To use the phase changing memory element in a memory cell, a selection device (not shown), such as a transistor, a diode, or another active device, may be coupled to the first electrode 1002 or to the second electrode 1006 to control the application of a current or a voltage to the phase changing material 1004 via the first electrode 1002 and/or the second electrode 1006. To set the phase changing material 1004 to the crystalline state, a current pulse and/or voltage pulse may be applied to the phase changing material 1004, wherein the pulse parameters are chosen such that the phase changing material 1004 is heated above its crystallization temperature, while keeping the temperature below the melting temperature of the phase changing material 1004. To set the phase changing material 1004 to the amorphous state, a current pulse and/or voltage pulse may be applied to the phase changing material 1004, wherein the pulse parameters are chosen such that the phase changing material 1004 is quickly heated above its melting temperature, and is quickly cooled.

The phase changing material 1004 may include a variety of materials. According to one embodiment, the phase changing material 1004 may include or consist of a chalcogenide alloy that includes one or more elements from group VI of the periodic table. According to another embodiment, the phase changing material 1004 may include or consist of a chalcogenide compound material, such as GeSbTe, SbTe, GeTe or AgInSbTe. According to a further embodiment, the phase changing material 1004 may include or consist of chalcogen free material, such as GeSb, GaSb, InSb, or GeGaInSb. According to still another embodiment, the phase changing material 1004 may include or consist of any suitable material including one or more of the elements Ge, Sb, Te, Ga, Bi, Pb, Sn, Si, P, O, As, In, Se, and S.

According to one embodiment, at least one of the first electrode 1002 and the second electrode 1006 may include or consist of Ti, V, Cr, Zr, Nb, Mo, Hf, Ta, W, or mixtures or alloys thereof. According to another embodiment, at least one of the first electrode 1002 and the second electrode 1006 may include or consist of Ti, V, Cr, Zr, Nb, Mo, Hf, Ta, W and two or more elements selected from the group consisting of B, C, N, O, Al, Si, P, S, and/or mixtures and alloys thereof. Examples of such materials include TiCN, TiAlN, TiSiN, W-Al₂O₃ and Cr-Al₂O₃.

FIG. 11 illustrates a block diagram of a PCRAM device 1100 including a write pulse generator 1102, a distribution circuit 1104, phase changing memory elements 1106 (for example phase changing memory elements 1000 as described above), and a sense amplifier 1108. According to one embodiment, the write pulse generator 1102 generates current pulses or voltage pulses that are supplied to the phase changing memory elements 1106 via the distribution circuit 1104, thereby programming the memory states of the phase changing memory elements 1106. According to one embodiment, the distribution circuit 1104 includes a plurality of transistors that supply direct current pulses or direct voltage pulses to the phase changing memory elements 1106 or to heaters (not shown) disposed adjacent to the phase changing memory elements 1106.

As already indicated, the phase changing material of the phase changing memory elements 1106 may be changed from the amorphous state to the crystalline state (or vice versa) under the influence of a temperature change. More generally, the phase changing material may be changed from a first degree of crystallization to a second degree of crystallization (or vice versa) under the influence of a temperature change. For example, a bit value "0" may be assigned to the first (low) degree of crystallization, and a bit value "1" may be assigned to the second (high) degree of crystallization. Since different degrees of crystallization imply different electrical resistances, the sense amplifier 1108 is capable of determining the memory state of one of the phase changing memory elements 1106 in dependence on the resistance of the phase changing material.

To achieve high memory densities, the phase changing memory elements 1106 may be capable of storing multiple bits of data, i.e. the phase changing material may be programmed to more than two resistance values. For example, if a phase changing memory element 1106 is programmed to one of three possible resistance levels, 1.5 bits of data per memory element can be stored. If the phase changing memory element is programmed to one of four possible resistance levels, two bits of data per memory element can be stored, and so on.

Thus, in summary, an embodiment of the invention provides an integrated circuit memory device including a non-volatile memory array that includes a first emulated memory region and a second emulated memory region, and a controller having a first interface. The memory device is configured to emulate a first emulated memory type and a second emulated memory type. The memory device is further configured to store data in the first emulated memory region when the memory device emulates the first emulated memory type, and in the second emulated memory region when the memory device emulates the second emulated memory type.

In some embodiments, the first emulated memory type is a non-volatile memory type and the second emulated memory type is a volatile memory type. In some embodiments, the first emulated memory type is NOR flash memory. In some embodiments, the second emulated memory type is pseudo-static random access memory (PSRAM).

In some embodiments, the first interface is configured to provide access to both the first emulated memory type and the second emulated memory type. Some such embodiments further include a selector, configured to select whether to emulate the first emulated memory type or the second emulated memory type. In certain of these embodiments, the selector is configured to determine whether to emulate the first emulated memory type or the second emulated memory type based at least in part on a memory address to be accessed. In some embodiments, the selector is configured to determine whether to emulate the first emulated memory type or the second emulated memory type based at least in part on the contents of a configuration register.

In some embodiments, the controller includes a first control portion that controls emulation of the first emulated memory type and a second control portion that controls emulation of the second emulated memory type. In some such embodiments, the controller further includes a second interface. The first interface may be associated with the first control portion, and the second interface may be associated with the second control portion. In some embodiments, the first interface includes a first chip enable line that enables the first control portion, and the second interface includes a second chip enable line that enables the second control portion. In some embodiments, the controller further includes a shared interface, having one or more lines that are shared by both the both the first control portion and the second control portion.

In some embodiments, the memory device emulates a timing of the first emulated memory type and a timing of the second emulated memory type. In some embodiments, the memory device uses an emulated refresh cycle of a volatile memory type to conceal a latency time for writing data to the non-volatile memory array. In some embodiments, the non-volatile memory array may include phase changing random access memory (PCRAM).

In some embodiments, the invention provides a method of providing access to multiple memory types within a single integrated circuit memory device. The method includes providing a non-volatile memory array including a first emulated memory region and a second emulated memory region, configuring the memory device to emulate a first memory type and a second memory type, configuring the memory device to store data in the first emulated memory region when the memory device emulates the first memory type, and configuring the memory device to store data in the second emulated memory region when the memory device emulates the second emulated memory type.

In some embodiments, configuring the memory device to emulate a first memory type and a second memory type includes configuring the memory device to emulate a non-volatile memory type, and configuring the memory device to emulate a volatile memory type. In some embodiments, configuring the memory device to emulate a non-volatile memory type includes configuring the memory device to emulate a NOR flash memory. In some embodiments, configuring the memory device to emulate a volatile memory type includes configuring the memory device to emulate a pseudo-static random access memory (PSRAM).

In some embodiments, configuring the memory device to emulate a first memory type and a second memory type includes providing a single interface to the first emulated memory type and the second emulated memory type. Some such embodiments further include providing a selector configured to determine whether to emulate the first memory type or the second memory type. In some embodiments, providing a selector includes providing a selector configured to determine whether to emulate the first memory type or the second memory type depending at least in part on a memory address. In some embodiments, providing a selector includes providing a selector configured to determine whether to emulate the first memory type or the second memory type depending at least in part on the contents of a configuration register.

In some embodiments, configuring the memory device to emulate a first memory type and a second memory type includes providing a first interface to the first memory type and providing a second interface to the second memory type. In some embodiments, providing a first interface to the first memory type includes providing a first chip select line that selects emulation of the first memory type, and providing a second interface to the second memory type includes providing a second chip select line that selects emulation of the second memory type.

In some embodiments, configuring the memory device to emulate a first memory type and a second memory type includes configuring the memory device to emulate a timing of the first emulated memory type and a timing of the second emulated memory type. In some embodiments, configuring the memory device to emulate a first memory type and a second memory type includes configuring the memory device to emulate a volatile memory type, and the method further includes using an emulated refresh cycle of the volatile memory type to conceal a latency time for writing data to the non-volatile memory array. In some embodiments, providing a non-volatile memory array includes providing a phase changing random access memory (PCRAM) array.

Some embodiments of the invention provide a memory device including a phase changing random access memory (PCRAM) array, a controller, a first chip enable line connected to the controller and configured to enable emulation of a flash memory, and a second chip enable line connected to the controller and configured to enable emulation of a pseudo-static random access memory (PSRAM). The memory device is configured to store data in a first area of the PCRAM array when the first chip enable line is set, and to store data in a second area of the PCRAM array when the second chip enable line is set.

In some embodiments, the invention provides an integrated circuit memory device including a non-volatile memory array having an emulated memory region configured to emulate a volatile memory type having a lower latency time than the non-volatile memory array. The memory device further includes a controller configured to emulate a refresh cycle of memory of the volatile memory type to provide additional time for writing to or reading from the emulated memory region of the non-volatile memory array while emulating the volatile memory type.

In some embodiments, the volatile memory type is pseudo-static random access memory (PSRAM). In some embodiments, the non-volatile memory array includes phase changing random access memory (PCRAM).

In some embodiments, the memory device further includes a first buffer memory, the first buffer memory storing data to be transferred to the emulated memory region. In some embodiments, the memory device further includes a second buffer memory, the second buffer memory storing data to be transferred to the emulated memory region. In some embodiments, the controller is further configured to store data in the first buffer memory until the first buffer memory is full, to store data in the second buffer memory while the contents of the first buffer memory are transferred to the emulated memory region, and to emulate the refresh cycle if the second buffer memory is full, and transferring the contents of the first buffer memory is not complete.

In some embodiments, the first buffer and the second buffer have latency times that are equal to or lower than the latency time of the volatile memory type. In some embodiments, the controller is further configured to emulate a non-volatile memory type.

In some embodiments, the invention provides a method of emulating a volatile memory type, including storing data in an emulated memory region of a non-volatile memory array, emulating the volatile memory type, the volatile memory type having a lower latency time than the non-volatile memory array, and emulating a refresh cycle of memory of the volatile memory type to provide additional time for writing to or reading from the emulated memory region of the non-volatile memory array.

In some embodiments, emulating the volatile memory type includes emulating a pseudo-static random access memory (PSRAM). In some embodiments, storing data in an emulated memory region of a non-volatile memory array includes storing data in an emulated memory region of a phase changing random access memory (PCRAM) array.

In some embodiments, storing data in an emulated region of a non-volatile memory array includes storing data in a first buffer memory, and transferring data from the first buffer memory to the emulated region of the non-volatile memory array.

In some embodiments, storing data in an emulated region of a non-volatile memory array includes storing data in a first buffer memory, and storing data in a second buffer memory and transferring data from the first buffer memory to the emulated region when the first buffer memory is full. Emulating a refresh cycle of memory of the volatile memory type may include emulating a refresh cycle of memory of the volatile memory type when the second buffer memory is full and transferring the contents of the first buffer memory is not complete. Some embodiments further include returning to storing data in the first buffer memory and transferring data from the second buffer memory to the emulated region when the second buffer memory is full. In such embodiments, emulating a refresh cycle of memory of the volatile memory type may include emulating a refresh cycle of memory of the volatile memory type when the first buffer memory is full and transferring the contents of the second buffer memory is not complete.

In some embodiments, storing data in a first buffer memory includes storing data in a first buffer memory having a latency time equal to or lower than a latency time of the volatile memory type, and storing data in a second buffer memory includes storing data in a second buffer memory having a latency time equal to or lower than a latency time of the volatile memory type. Some embodiments further include emulating a non-volatile memory type.

In some embodiments, the invention provides a memory device including a phase changing random access memory (PCRAM) array, and a controller. The controller is configured to emulate a volatile memory type having a lower latency time than the PCRAM array by storing data in the PCRAM array, and emulating a refresh cycle of memory of the volatile memory type to provide additional time for writing to or reading from the PCRAM array.

In some embodiments, the volatile memory type is pseudo-static random access memory (PSRAM). In some embodiments, the memory device further includes a first buffer memory, the first buffer memory storing data to be transferred to the PCRAM array. Some embodiments further include a second buffer memory, the second buffer memory storing data to be transferred to the PCRAM array.

In some embodiments, the controller is further configured to store data in the first buffer memory until the first buffer memory is full, to store data in the second buffer memory while the contents of the first buffer memory are transferred to the PCRAM array, and to emulate the refresh cycle if the second buffer memory is full, and transferring the contents of the first buffer memory is not complete. In some embodiments, the first buffer and the second buffer have latency times that are equal to or lower than the latency time of the volatile memory type.

In some embodiments, the invention provides an integrated circuit memory device including a memory array, a controller, a buffer configured to store information that is read from the memory array or that is to be written to the memory array, and a buffer configuration register configured to control an operation of the buffer. The memory device is configured to emulate an emulated memory type different from the memory type of the memory array, and to store data in a first portion of the memory array when the memory device emulates the first emulated memory type.

In some embodiments, the buffer configuration register is configured to instruct the buffer to transfer data to the first portion of the memory array after a "flush" command is stored in the buffer configuration register. In some embodiments, the buffer configuration register is configured to instruct the buffer to transfer its contents after an additional write command is issued for the emulated memory type. In some embodiments, the buffer configuration register is configured to instruct the buffer to transfer the entire contents of the buffer. In some embodiments, the buffer is arranged as a plurality of blocks, and the buffer configuration register is configured to instruct the buffer to transfer a specified block from the plurality of blocks.

In some embodiments, the controller is configured to set a busy signal prior to transferring data to the first portion of the memory array, and the busy signal is reset after transferring the data. In some embodiments, the emulated memory type is a volatile memory type, and the busy signal includes a refresh signal for the emulated memory type.

In some embodiments, the buffer configuration register is configured to instruct the buffer to transfer data from the first portion of the memory array after a "read" command is stored in the buffer configuration register. In some such embodiments, the buffer is arranged as a plurality of blocks, and the buffer configuration register is configured to instruct the buffer to transfer a specified block from the plurality of blocks. In some embodiments, the controller is configured to set a busy signal prior to transferring data to the first portion of the memory array, and the busy signal is reset after transferring the data.

In some embodiments, the buffer configuration register is configured according to properties of the emulated memory type.

In some embodiments, the invention provides a method of providing access to an emulated memory type. The method includes providing a memory array, emulating an emulated memory type, different than the memory type of the memory array, storing data that are read from the memory array or that are to be written to the memory array in a buffer, and using a buffer configuration register to control the operation of the buffer.

In some embodiments, using a buffer configuration register to control the operation of the buffer includes instructing the buffer to transfer data to the first portion of the memory array by placing a "flush" command in the buffer configuration register. Some embodiments further include waiting until an additional write command is issued for the emulated memory type before transferring the data. In some embodiments, instructing the buffer to transfer data to the first portion of the memory array includes instructing the buffer to transfer the entire contents of the buffer. In some embodiments, instructing the buffer to transfer data to the first portion of the memory array includes instructing the buffer to transfer a selected portion of the contents of the buffer.

Some embodiments further include setting a busy signal prior to transferring data from the buffer to the first portion of the memory array, and resetting the busy signal after transferring data from the buffer to the first portion of the memory array. In some such embodiments, emulating an emulated memory type includes emulating a volatile memory type, and setting a busy signal includes setting a refresh signal for the volatile memory type.

In some embodiments, using a buffer configuration register to control the operation of the buffer includes instructing the buffer to transfer data from the first portion of the memory array by placing a "read" command in the buffer configuration register. In some embodiments, instructing the buffer to transfer data from the first portion of the memory array includes instructing the buffer to transfer a selected portion of the contents of the buffer.

In some embodiments, using a buffer configuration register to control the operation of the buffer includes setting the buffer configuration register to adjust the performance of the memory device in accordance with a property of the emulated memory type. In some embodiments, setting the buffer configuration register to adjust the performance of the memory device in accordance with a property of the emulated memory type includes setting the buffer register to adjust the performance of the memory device in accordance with a timing of the emulated memory type. In some embodiments, providing a memory array includes providing a non-volatile memory array.

In some embodiments, the invention provides a memory device including a phase changing random access memory (PCRAM) array, a controller, a buffer configured to store information that is read from the PCRAM array or that is to be written to the PCRAM array, the buffer having a latency that is substantially lower than a latency for the PCRAM array, and a buffer configuration register configured to control reading data to the buffer and flushing data from the buffer. The memory device is configured to emulate a volatile memory type, and to store data in a first portion of the PCRAM array when the memory device emulates the first emulated memory type. In some embodiments, the buffer configuration register is configured to cause the memory device to emulate a timing property of the volatile memory type.

In some embodiments, a method of providing access to multiple memory types within a single integrated circuit memory device is provided. The method may include providing a non-volatile memory array having a first emulated memory region and a second emulated memory region, configuring the memory device to emulate a first memory type and a second memory type, configuring the memory device to store data in the first emulated memory region when the memory device emulates the first memory type, and configuring the memory device to store data in the second emulated memory region when the memory device emulates the second emulated memory type.

In an implementation of this embodiment, configuring the memory device to emulate a first memory type and a second memory type may include configuring the memory device to emulate a non-volatile memory type, and configuring the memory device to emulate a volatile memory type.

In another implementation of this embodiment, configuring the memory device to emulate a non-volatile memory type may include configuring the memory device to emulate a NOR flash memory.

In yet another implementation of this embodiment, configuring the memory device to emulate a volatile memory type may include configuring the memory device to emulate a pseudo-static random access memory (PSRAM).

In yet another implementation of this embodiment, configuring the memory device to emulate a first memory type and a second memory type may include providing a single interface to the first emulated memory type and the second emulated memory type.

In yet another implementation of this embodiment, the method may further include providing a selector configured to determine whether to emulate the first memory type or the second memory type.

In yet another implementation of this embodiment, providing a selector may include providing a selector configured to determine whether to emulate the first memory type or the second memory type depending at least in part on a memory address.

In yet another implementation of this embodiment, providing a selector may include providing a selector configured to determine whether to emulate the first memory type or the second memory type depending at least in part on the contents of a configuration register.

In yet another implementation of this embodiment, configuring the memory device to emulate a first memory type and a second memory type may include providing a first interface to the first memory type and providing a second interface to the second memory type.

In yet another implementation of this embodiment, providing a first interface to the first memory type may include providing a first chip select line that selects emulation of the first memory type, and wherein providing a second interface to the second memory type may include providing a second chip select line that selects emulation of the second memory type.

In yet another implementation of this embodiment, configuring the memory device to emulate a first memory type and a second memory type may include configuring the memory device to emulate a timing of the first emulated memory type and a timing of the second emulated memory type.

In yet another implementation of this embodiment, configuring the memory device to emulate a first memory type and a second memory type may include configuring the memory device to emulate a volatile memory type, and the method may further include using an emulated refresh cycle of the volatile memory type to conceal a latency time for writing data to the non-volatile memory array.

In yet another implementation of this embodiment, providing a non-volatile memory array may include providing a phase changing random access memory (PCRAM) array.

In some embodiments, a memory device may be provided. The memory device may include a phase changing random access memory (PCRAM) array, a controller, a first chip enable line connected to the controller and configured to enable emulation of a flash memory, a second chip enable line connected to the controller and configured to enable emulation of a pseudo-static random access memory (PSRAM). The memory device may be configured to store data in a first area of the PCRAM array when the first chip enable line is set, and to store data in a second area of the PCRAM array when the second chip enable line is set.

While the invention has been particularly shown and described with reference to specific embodiments, it should be understood by those skilled in the art that various changes in form and detail may be made therein without departing from the spirit and scope of the invention. For example, while the invention has been described as using PCRAM to emulate PSRAM and NOR flash, it will be understood that other types of memory may be emulated, and other types of non-volatile memory, such as CBRAM, carbon memory, MRAM or other non-volatile memory technologies may be used for the emulation. The scope of the invention is thus indicated by the appended claims and all changes which come within the meaning and range of equivalency of the claims are therefore intended to be embraced.

## Claims

1. An integrated circuit memory device (300) comprising:
• a non-volatile memory array (302) comprising a first emulated memory region (304) and a second emulated memory region (306),
and
• a controller (312) having a first interface, wherein the first interface is configured to provide access to both the first emulated memory type (304) and the second emulated memory type (306); **characterized in that**:
• the non-volatile memory array (302) is a non-volatile memory technology; the first interface is coupled to chip select lines (318, 320) such that it can determine if the memory being emulated is the first or second emulated region, and the first interface is further coupled to data lines (324) and address lines (322);
• the memory device is configured to store data in the first emulated memory region (304) when the memory device emulates the first emulated memory type, and in the second emulated memory region (306) when the memory device emulates the second emulated memory type.

2. The memory device (300) of claim 1, wherein the first emulated memory type is a non-volatile memory type and the second emulated memory type is a volatile memory type.

3. The memory device (300) of claim 2, wherein the first emulated memory type is NOR flash memory.

4. The memory device (300) of any one of the claims 2 or 3, wherein the second emulated memory type is pseudo-static random access memory (PSRAM).

5. The memory device (300) of claim 1, further comprising a selector, configured to select whether to emulate the first emulated memory type or the second emulated memory type.

6. The memory device (300) of claim 5, wherein the selector is configured to determine whether to emulate the first emulated memory type or the second emulated memory type based at least in part on a memory address to be accessed.

7. The memory device (300) of any one of the claims 5 or 6, wherein the selector is configured to determine whether to emulate the first emulated memory type or the second emulated memory type based at least in part on the contents of a configuration register (506).

8. The memory device (300) of any one of the claims 1 to 7, wherein the controller (312) comprises a first control portion (314) that controls emulation of the first emulated memory type and a second control portion (316) that controls emulation of the second emulated memory type.

9. The memory device (300) of claim 8, wherein the controller (312) further comprises a second interface, and wherein the first interface is associated with the first control portion (314), and the second interface is associated with the second control portion (316).

10. The memory device (300) of claim 9, wherein the first interface comprises a first chip enable line (318) that enables the first control portion (314), and the second interface comprises a second chip enable line (320) that enables the second control portion (316).

11. The memory device (300) of any one of the claims 9 or 10, wherein the controller (312) further comprises a shared interface, comprising one or more lines that are shared by both the both the first control portion and the second control portion.

12. The memory device (300) of any one of the claims 1 to 11, wherein the memory device emulates a timing of the first emulated memory type and a timing of the second emulated memory type.

13. The memory device (300) of any one of the claims 1 to 12, wherein the memory device uses an emulated refresh cycle of a volatile memory type to conceal a latency time for writing data to the non-volatile memory array (302).

14. The memory device (300) of any one of the claims 1 to 13, wherein the non-volatile memory array (302) comprises phase changing random access memory (PCRAM).

15. A method of providing access to multiple memory types within a single integrated circuit memory device (300), the method comprising:
• providing a non-volatile memory array (302) comprising a first emulated memory region (304) and a second emulated memory region (306),
• configuring the memory device (300) to emulate a first memory type and a second memory type,
• providing a controller (312) having a first interface, wherein the first interface is configured to provide access to both the first emulated memory type (304) and the second emulated memory type (306);
**characterized in that**:
the non-volatile memory array (302) is a non-volatile memory technology;
• the first interface is coupled to chip select lines (318, 320) such that it can determine if the memory being emulated is the first or second emulated region, and wherein the first interface is further coupled to data lines (324) and address lines (322);
• configuring the memory device (300) to store data in the first emulated memory region (304) when the memory device emulates the first memory type, and
• configuring the memory device (300) to store data in the second emulated memory region (306) when the memory device (300) emulates the second emulated memory type.

## Patentansprüche

1. Speichervorrichtung (300) mit integrierten Schaltkreisen, aufweisend:
• eine nichtflüchtige Speicherzellenanordnung (302), die einen ersten emulierten Speicherbereich (304) und einen zweiten emulierten Speicherbereich (306) aufweist;
• einen Kontroller (312), der eine erste Schnittstelle aufweist, wobei die erste Schnittstelle dazu eingerichtet ist, Zugriff sowohl auf den ersten emulierten Speichertyp (304) als auch auf den zweiten emulierten Speichertyp (306)
bereitzustellen;
**dadurch gekennzeichnet, dass**
• die nichtflüchtige Speicherzellenanordnung (302) eine nichtflüchtige Speichertechnologie ist;
• die erste Schnittstelle mit den Chipauswahlleitungen (318, 320) derart gekoppelt ist, dass sie ermitteln kann, ob der gerade emulierte Speicher der erste oder der zweite emulierte Bereich ist, und die erste Schnittstelle ferner mit Datenleitungen (324) und Adressleitungen (322) gekoppelt ist;
• die Speichervorrichtung dazu eingerichtet ist, Daten in dem ersten emulierten Speicherbereich (304) zu speichern, wenn die Speichervorrichtung den ersten emulierten Speichertyp emuliert, und in dem zweiten emulierten Speicherbereich (306) zu speichern, wenn die Speichervorrichtung den zweiten emulierten Speichertyp emuliert.

2. Speichervorrichtung (300) nach Anspruch 1, wobei der erste emulierte Speichertyp ein nichtflüchtiger Speichertyp ist
und der zweite emulierte Speichertyp ein flüchtiger Speichertyp ist.

3. Speichervorrichtung (300) nach Anspruch 2, wobei der erste emulierte Speichertyp ein NOR-Flash-Speicher ist.

4. Speichervorrichtung (300) nach einem der Ansprüche 2 oder 3, wobei der zweite emulierte Speichertyp ein pseudostatischer Direktzugriffsspeicher (PSRAM) ist.

5. Speichervorrichtung (300) nach Anspruch 1, ferner aufweisend eine Auswahlvorrichtung, die dazu eingerichtet ist, auszuwählen, ob der erste emulierte Speichertyp oder der zweite emulierte Speichertyp emuliert wird.

6. Speichervorrichtung (300) nach Anspruch 5, wobei die Auswahlvorrichtung dazu eingerichtet ist, basierend zumindest zum Teil auf einer Speicheradresse, auf die zugegriffen werden soll, zu ermitteln, ob der erste emulierte Speichertyp oder der zweite emulierte Speichertyp emuliert wird.

7. Speichervorrichtung (300) nach einem der Ansprüche 5 oder 6, wobei die Auswahlvorrichtung dazu eingerichtet ist, basierend zumindest zum Teil auf den Inhalten eines Konfigurationsregisters (506) zu ermitteln, ob der erste emulierte Speichertyp oder der zweite emulierte Speichertyp emuliert wird.

8. Speichervorrichtung (300) nach einem der Ansprüche 1 bis 7, wobei der Kontroller (312) einen ersten Steuerabschnitt (314), der die Emulation des ersten Speichertyps steuert, und einen zweiten Steuerabschnitt (316) aufweist, der die Emulation des zweiten emulierten Speichertyps steuert.

9. Speichervorrichtung (300) nach Anspruch 8, wobei der Kontroller (312) ferner eine zweite Schnittstelle aufweist und wobei die erste Schnittstelle mit dem ersten Steuerabschnitt (314) verbunden ist und die zweite Schnittstelle mit dem zweiten Steuerabschnitt (316) aufweist.

10. Speichervorrichtung (300) nach Anspruch 9, wobei die erste Schnittstelle eine erste Chip-Freigabeleitung (318) aufweist, die den ersten Steuerabschnitt (314) aktiviert, und die zweite Schnittstelle eine zweite Chip-Freigabeleitung (320) aufweist, die den zweiten Steuerabschnitt (316) aktiviert.

11. Speichervorrichtung (300) nach einem der Ansprüche 9 oder 10, wobei der Kontroller (312) ferner eine gemeinsame Schnittstelle aufweist, die eine oder mehrere Leitungen aufweist, die sowohl von dem ersten Steuerabschnitt als auch dem zweiten Steuerabschnitt geteilt werden.

12. Speichervorrichtung (300) nach einem der Ansprüche 1 bis 11, wobei die Speichervorrichtung eine Zeitsteuerung des ersten emulierten Speichertyps und eine Zeitsteuerung des zweiten emulierten Speichertyps emuliert.

13. Speichervorrichtung (300) nach einem der Ansprüche 1 bis 12, wobei die Speichervorrichtung einen emulierten Auffrischungszyklus eines flüchtigen Speichertyps verwendet, um die Latenzzeit zum Schreiben von Daten in die nichtflüchtige Speicherzellenanordnung (302) zu kaschieren.

14. Speichervorrichtung (300) nach einem der Ansprüche 1 bis 13, wobei die nichtflüchtige Speicherzellenanordnung (302) einen Phasenänderungsdirektzugriffsspeicher (PCRAM) aufweist.

15. Verfahren zum Bereitstellen eines Zugriffs auf mehrere Speichertypen innerhalb einer einzigen Speichervorrichtung (300) mit integrierten Schaltkreisen, wobei das Verfahren aufweist:
• Bereitstellen einer nichtflüchtigen Speicherzellenanordnung (302), die einen ersten emulierten Speicherbereich (304) und einen zweiten emulierten Speicherbereich (306) aufweist;
• Konfigurieren der Speichervorrichtung (300) derart, dass ein erster Speichertyp und ein zweiter Speichertyp emuliert wird,
• Bereitstellen eines Kontrollers (312) mit einer ersten Schnittstelle, wobei die erste Schnittstelle dazu eingerichtet ist, Zugriff sowohl auf den ersten emulierten Speichertyp (304) als auch auf den zweiten emulierten Speichertyp (306) bereitzustellen;
**dadurch gekennzeichnet, dass**
• die nichtflüchtige Speicherzellenanordnung (302) eine nichtflüchtige Speichertechnologie ist;
• die erste Schnittstelle mit den Chipauswahlleitungen (318, 320) derart gekoppelt ist, dass sie ermitteln kann, ob der gerade emulierte Speicher der erste oder der zweite emulierte Bereich ist, und wobei die erste Schnittstelle ferner mit Datenleitungen (324) und Adressleitungen (322) gekoppelt ist;
• Konfigurieren der Speichervorrichtung (300) derart, dass Daten in dem ersten emulierten Speicherbereich (304) gespeichert werden, wenn die Speichervorrichtung den ersten Speichertyp emuliert, und
• Konfigurieren der Speichervorrichtung (300) derart, dass Daten in dem zweiten emulierten Speicherbereich (306) gespeichert werden, wenn die Speichervorrichtung (300) den zweiten emulierten Speichertyp emuliert.

## Revendications

1. Dispositif (300) de mémoire à circuit intégré comprenant :
• une matrice (302) de mémoire rémanente, comprenant une première région (304) de mémoire émulée et une deuxième région (306) de mémoire émulée et
• un contrôleur (312) ayant une première interface, la première interface étant configurée pour procurer un accès à la fois au premier type (304) de mémoire émulée et au second type (306) de mémoire émulée ;
**caractérisé en ce que**
• la matrice (302) de mémoire rémanente est une technologie de mémoire rémanente,
• la première interface est couplée à des lignes (318, 320) de sélection de puces, de manière à ce qu'elle puisse déterminer, si la mémoire est émulée, si c'est la première ou la deuxième région qui est émulée, et la première interface est couplée, en outre, à des lignes (324) de données et des lignes (326) d'adresse ;
• le dispositif de mémoire est configuré pour mémoriser des données dans la première région (304) de mémoire émulée, lorsque le dispositif de mémoire émule le premier type de mémoire émulé, et dans la deuxième région (306) de mémoire émulée, lorsque le dispositif de mémoire émule le deuxième type de mémoire émulé.

2. Dispositif (300) de mémoire suivant la revendication 1, dans lequel le premier type de mémoire émulé est un type de mémoire rémanente et le deuxième type de mémoire émulé est un type de mémoire non-rémanente.

3. Dispositif (300) de mémoire suivant la revendication 2, dans lequel le premier type de mémoire émulé est une mémoire flash NON OU.

4. Dispositif (300) de mémoire suivant l'une quelconque des revendications 2 ou 3, dans lequel le deuxième type de mémoire émulé est une mémoire vive pseudostatique (PSRAM).

5. Dispositif (300) de mémoire suivant la revendication 1, comprenant, en outre, un sélecteur configuré pour sélectionner si l'on doit émuler le premier type de mémoire émulé ou le deuxième type de mémoire émulé.

6. Dispositif (300) de mémoire suivant la revendication 5, dans lequel le sélecteur est configuré pour déterminer si l'on doit émuler le premier type de mémoire émulé ou le deuxième type de mémoire émulé sur la base, au moins en partie, d'une adresse de mémoire à laquelle on doit accéder.

7. Dispositif (300) de mémoire suivant l'une quelconque des revendications 5 ou 6, dans lequel le sélecteur est configuré pour déterminer si on doit émuler le premier type de mémoire émulé ou le deuxième type de mémoire émulé sur la base, au moins en partie, des contenus d'un registre (506) de configuration.

8. Dispositif (300) de mémoire suivant l'une quelconque des revendications 1 à 7, dans lequel le contrôleur (312) comprend une première partie (314) de commande, qui commande l'émulation du premier type de mémoire émulé, et
une deuxième partie (316) de commande, qui commande l'émulation du deuxième type de mémoire émulé.

9. Dispositif (300) de mémoire suivant la revendication 8, dans lequel le contrôleur (312) comprend, en outre, une deuxième interface et la première interface est associée à la première partie (314) de commande et la deuxième interface est associée à la deuxième partie (316) de commande.

10. Dispositif (300) de mémoire suivant la revendication 9, dans lequel la première interface comprend une première ligne (318) de validation de puce, qui valide la première partie (314) de commande, et la deuxième interface comprend une deuxième ligne (320) de validation, qui valide la deuxième partie (316) de commande.

11. Dispositif (300) de mémoire suivant l'une quelconque des revendications 9 ou 10, dans lequel le contrôleur (312) comprend, en outre, une interface partagée comprenant une ligne ou plusieurs lignes, qui sont partagées à la fois par la première partie de commande et par la deuxième partie de commande.

12. Dispositif (300) de mémoire suivant l'une quelconque des revendications 1 à 11, dans lequel le dispositif de mémoire émule une synchronisation du premier type de mémoire émulé et une synchronisation du deuxième type de mémoire émulé.

13. Dispositif (300) de mémoire suivant l'une quelconque des revendications 1 à 12, dans lequel le dispositif de mémoire utilise un cycle de régénération émulé d'un type de mémoire non-rémanente pour dissimuler un temps de latence pour écrire des données dans la matrice (302) de mémoire rémanente.

14. Dispositif (300) de mémoire suivant l'une quelconque des revendications 1 à 13, dans lequel la matrice (302) de mémoire rémanente comprend une mémoire vive à changement de phase (PCRAM).

15. Procédé pour procurer un accès à des types de mémoire multiples au sein d'un dispositif (300) de mémoire unique à circuits intégrés, procédé dans lequel :
• on se procure une matrice (302) de mémoire rémanente comprenant une première région (304) de mémoire émulée et une deuxième région (306) de mémoire émulée ;
• on configure le dispositif (300) de mémoire pour émuler un premier type de mémoire et un deuxième type de mémoire ;
• on se procure un contrôleur (312) ayant une première interface, la première interface étant configurée pour procurer un accès à la fois au premier type (304) de mémoire émulé et au deuxième type (306) de mémoire émulé ;
**caractérisé en ce que** :
• la matrice (302) de mémoire rémanente est une technologie de mémoire rémanente ;
• la première interface est couplée à des lignes (318, 320) de sélection de puces, de manière à ce qu'elle puisse déterminer si la mémoire est émulée, si c'est la première ou la deuxième région émulée qui est émulée, et la première interface est, en outre, couplée à des lignes (324) de données et à des lignes (322) d'adresse ;
• on configure le dispositif (300) de mémoire pour mémoriser des données dans la première région (304) de mémoire émulée, lorsque le dispositif de mémoire émule le premier type de mémoire, et
• on configure le dispositif (300) de mémoire pour mémoriser des données dans la deuxième région (306) de mémoire émulée, lorsque le dispositif (300) de mémoire émule le deuxième type de mémoire émulé.
